# EUROPEAN PATENT SPECIFICATION

(11) **EP 3 219 832 B1**
(45) Date of publication and mention of the grant of the patent: **24.06.2020**
(21) Application number: 16160751.0
(22) Date of filing: 16.03.2016
(51) Int. Cl.: C30B 23/02, C30B 29/40, C30B 33/06, G02B 5/08, C30B 29/68, H01L 21/18

(54) **METHOD FOR MANUFACTURING DIRECT-BONDED OPTICAL COATINGS**
VERFAHREN ZUR HERSTELLUNG VON DIREKT VERBUNDENEN OPTISCHEN BESCHICHTUNGEN
PROCÉDÉ POUR LA FABRICATION DES REVÊTEMENTS OPTIQUES À LIAISON DIRECTE

(43) Date of publication of application: 20.09.2017
(73) Proprietor: Thorlabs Inc., Newton, New Jersey 07860 (US)
(72) Inventor: Cole, Garrett, Santa Barbara, CA California 93103 (US); Follman, David, Niskayuna, NY 12309 (US); Heu, Paula, Santa Barbara, CA California 93111 (US)
(74) Representative: Grünecker Patent- und Rechtsanwälte PartG mbB

(56) References cited:
- EP-A1- 2 607 935
- GB-A- 2 346 480
- GARRETT D. COLE ET AL: "Tenfold reduction of Brownian noise in high-reflectivity optical coatings", NATURE PHOTONICS, vol. 7, no. 8, 1 August 2013 (2013-08-01), pages 644-650, XP055085841, ISSN: 1749-4885, DOI: 10.1038/nphoton.2013.174
- Yu Bai ET AL: "Fabrication of GaAs-on-Insulator via Low Temperature Wafer Bonding and Sacrificial Etching of Ge by XeF2", Journal of The Electrochemical Society, 28 December 2011 (2011-12-28), pages H183-190, XP055302312, DOI: 10.1149/2.070202jes Retrieved from the Internet: URL:http://jes.ecsdl.org/content/159/2/H18 3.full.pdf [retrieved on 2016-09-13]

## Description

### Field of the present disclosure

The present disclosure relates to a method for manufacturing a low optical loss direct-bonded mirror assembly.

### Background of the present disclosure

Highly reflective optical interference coatings are indispensable tools for modern scientific and industrial efforts. Systems with ultralow optical losses, namely parts-per-million, ppm, levels of scatter and absorption, were originally developed for the construction of ring-laser gyroscopes in the late 1970s, cf. US 4,142,958. As an outcome of this, ion-beam sputtering, IBS, has been established as the gold standard process technology for generating ultralow-loss reflectors in the visible and near infrared, NIR. Typically, such multilayers consist of alternating layers of amorphous metal-oxides, most commonly high index Ta₂O₅, tantala, and low index SiO₂, silica, thin films, finding application in narrow-linewidth laser systems for optical atomic clocks, gravitational wave detectors, cavity QED, and tests of fundamental physics. Still, limitations of these amorphous coatings include excess Brownian noise, negatively impacting the limiting performance of precision optical interferometers, poor thermal conductivity, typically below 1 Wm⁻¹K⁻¹ as well as significant levels of optical absorption for wavelengths beyond 2 µm, excluding operation of such low-loss reflectors in the mid-infrared, MIR. The latter limitation means that the highest performing metal oxide structures, while exhibiting phenomenal performance in the visible and NIR, cannot operate with low losses in this important long-wavelength region and thus requires a switch to amorphous II-VI, group IV, or IV-VI compounds.

In addition to their poor thermal conductivity and high losses in the MIR, these state-of-the-art multilayer mirror materials also fail to fulfill the demanding requirements, in terms of thermal noise, for applications in precision interferometry. Specific examples include the specifications for low-Brownian noise cavity end mirrors implemented in high performance optical systems such as gravitational wave interferometers and optical reference cavities for sub-Hz linewidth cavity-stabilized lasers. Here, the relatively high mechanical dissipation, with loss angles greater than or equal to 10⁻⁴, in these amorphous thin films leads to excess Brownian noise, and now stands as one of the major factors limiting the overall sensitivity and stability of these systems. In depth studies with regard to the coating properties have shown that the mechanical loss of the mirror coating is dominated by the damping in the Ta₂O₅ layers. Reduction of this loss has been attempted by modifying this material through doping, annealing, etc. or by replacing the Ta₂O₅ with alternative high refractive index films such as hafnia, HfO₂, and zirconia, ZrO₂. However, such modifications typically result in less than a factor of two reduction in the mechanical damping, with loss angles near 2×10⁻⁴.

Cole, G. et al, "Tenfold reduction of Brownian noise in high-reflectivity optical coatings", Nature Photonics volume 7, pages 644-650 (2013), discloses a substrate-transfer coating procedure including separating the epitaxial multilayer from the original growth wafer and directly bonding it to the desired mirror blank.

Yu Bai et al., "Fabrication of GaAs-on-Insulator via Low Temperature Wafer Bonding and Sacrificial Etching of Ge by XeF2", Journal of the Electrochemical Society, 2012 volume 159, issue 2, pages H183-H190, discloses a low temperature process for the fabrication of GaAs-on-insulator structures.

GB 2 346 480 A discloses a device having high quality surfaces on both sides of an AlₓGa_{y}In_{z}N device and a method of fabricating such a device.

EP 2 607 935 A1 discloses a mirror assembly based on a monocrystalline Bragg mirror bonded to a curved carrier substrate and a process of manufacturing the mirror assembly. Additionally, this patent describes an optical resonator system comprising a pair of such mirror assemblies forming an optical cavity for application in optical precision measurement systems. Processes disclosed therein proved very robust from a manufacturing point of view and have been proven to yield up to an order of magnitude reduction in Brownian noise when compared with typical dielectric mirror systems, with demonstrated loss angles <4×10⁻⁵ at room temperature and the potential for ∼5×10⁻⁶ at cryogenic temperatures near 10 K. Given the rapidly expanding interest in such low-noise end mirrors, further improvements of the optical performance of these substrate-transferred crystalline coatings, particularly the position dependence of the optical scatter losses, is now in high demand from the ultimate end users.

### Summary of the present disclosure

The present disclosure provides an alternative solution to overcome the above-mentioned limitations, namely a means to reduce the overall optical losses and improve the position dependence of the coating optical properties. With the use of crystalline multilayers of high mechanical quality, it also serves to significantly reduce the Brownian noise of the mirror materials while simultaneously exhibiting optical performance on par with IBS deposited multilayer mirrors.

Within the present disclosure, the term crystalline, single crystal or monocrystalline refers to a low defect density single-crystal film as can be produced via epitaxial growth techniques, such as molecular beam epitaxy, MBE; metalorganic vapor phase epitaxy, MOVPE; liquid phase epitaxy, LPE; etc. In this application the terms crystalline and monocrystalline may be used interchangeably. It is important to note that a single crystal or monocrystalline material structure will still exhibit a finite number of defects or dislocations. However, a monocrystalline material does not contain grain boundaries and defects associated with said boundaries, separating neighbouring crystallites of varying orientation in a polycrystalline sample.

Within the present disclosure the term low absorption should be understood to indicate an absorption level with a maximum upper limit of 50 - 100 ppm. Preferably, this may be reduced to < 10 ppm or even into the range below 1 ppm.

Within the present disclosure, the term "dielectric multilayer coating" corresponds to a "thin film coating" which may also be referred to as a "multilayer mirror." The term mirror assembly refers to the multilayer coating together with the substrate.

Within the present disclosure the term growth substrate should be understood as a synonym for donor substrate.

The present disclosure provides a method for manufacturing a direct-bonded optical coating, comprising: providing a growth substrate; providing an optical substrate; wherein the optical substrate is curved having a radius of curvature, ROC, between 0.1 m and 10 m or between 1 km and 10 km; forming the optical coating directly on the growth substrate, the optical coating having a top surface facing away from the growth substrate; flipping the optical coating such that the top surface of the optical coating faces the optical substrate; directly bonding the top surface of the optical coating to the optical substrate without any intermediate adhesive layers; and detaching the growth substrate from the optical coating after the bonding step; wherein the bonding step comprises: pressing the optical coating into direct contact with the optical substrate surface using a press, thereby obtaining a bond between the optical coating and the optical substrate, wherein if the optical substrate has a concave surface using a convex press of equal and opposite or smaller radius of curvature, wherein the pressing is realized by clamping together the optical substrate, optical coating, and the press at a controlled pressure value; and further comprising annealing of the bonded optical substrate for example at a temperature between 90 °C - 300 °C and for times spanning one to twenty four hours.

It should be understood that both the growth substrate and the optical substrate, being of finite thickness, are comprised of two surfaces, one of which may be identified as the top surface of the respective substrate, the other as the bottom surface. For both the growth substrate and the optical substrate, one of the two surfaces of each substrate will be chosen as the surface on which further work is applied. That surface will then be identified as being the top surface of the respective substrate.

The term flipping should be understood as rotating or turning over the growth substrate having the coating attached thereon by 180°.

This process enables significant improvements in the coating optical performance without changing the coating material structure or initial crystal growth process. Optical coating performance is a function of the material reflectivity, controlled by the transmission, absorption, and scatter of light at the designed wavelength of operation. Transmission can be readily defined assuming excellent uniformity and thickness control of the individual layers making up the multilayer interference coating. Absorption can be minimized by making sure that the individual layers are transparent at the wavelength of interest, i.e. having a band gap energy exceeding that of the incident light, as well as by reducing the impurity concentration in the films. Optical scatter losses typically result from contamination of the coating surface from foreign particles, surface roughness, or embedded or surface defects in or on the coating material resulting from the material growth or deposition process. Both the density of embedded defects and surface roughness tend to increase as a function of the film thickness. Defects embedded in the material are incorporated during the coating growth process and typically increase in density from the coating initial growth layer up to top coating layer. This is a consequence of the lack of planarization during deposition, i.e. each embedded defect creates a small "bump" or local raised area that propagates to the surface of the coating. Thus, the top surface of the directly deposited coating shows the integrated sum of all defects incorporated in the growth process.

With a coating grown on a super polished substrate, with typical RMS roughness values at the ∼1 Å level, the back surface of the coating typically exhibits very low roughness, with the original growth substrate effectively acting as a template, as well as a low defect density. By flipping the coating upside down during the substrate transfer and bonding process, thereby exposing what was originally the back surface of the coating to the optical field, the coating's final surface may show a significant enhancement in quality, owing to a decrease in the density of surface defects, as well as a minimized surface roughness. As a consequence of the flipping process, growth related defects are buried at the bond interface. Thus it is extremely important that the defect density and roughness be low enough for successful bonding. Following successful bonding, the flipped coating may exhibit a significant reduction in optical scatter loss, with the potential for uniform losses at the parts-per-million, ppm, level. This reduced scatter loss leads to a commensurate increase in coating performance, with the potential for cavity finesse levels in the few hundred thousand range. The finesse or finesse level of an optical resonator, i.e. cavity, is defined as its free spectral range divided by the full width at half-maximum linewidth of its optical resonances. It is fully determined by the resonator losses, including optical scatter, absorption, and transmission, and is independent of the resonator length.

This process reduces the impact of surface scatterers while also allowing for scalable manufacturing throughput. In this way both passive and electro-optically active coatings may still be realized. These coatings may include single or multilayer structures and may be transferred to arbitrary optical substrates, including those with curved surfaces. The final donor substrate may act simultaneously as a mechanical support, heat spreader and or heat sink, as well as allowing optical access assuming the use of an optical substrate that is transparent at the desired operating wavelength.

As indicated, in this process the coating is inverted, e.g. flipped, during the transfer process, and the original top surface of the coating is directly bonded to the optical substrate. The step of detaching the growth substrate from the coating may be performed either before or else after the bonding step. The order of operations will ultimately depend on a few factors. For very tightly curved optical substrates, for example an optical substrate with a radius of curvature, ROC, less than 0.5 m, removal of the donor substrate prior to bonding will generate an extremely flexible structure, as the typical coating thickness is <20 µm. However, as these thin structures are quite fragile, the maximum coating size may be limited to less than 20 mm diameter. For larger coating areas being transferred to less severely curved optical substrates, it is preferred to remove the growth substrate after bonding. Another advantage of this option is that the growth substrate can be used to protect the coating until the final process step. After bonding and substrate removal, or substrate removal and inverted bonding, the newly exposed top surface, which was originally the base of the coating, exhibits a significantly lower defect density.

The annealing process can be used to strengthen the bond, with an optimized process enabling bulk bond strength values at the ∼1 J/cm² level. The final temperature chosen will depend on the relative mismatch of the thermal expansion coefficients of the coating and the optical substrate. For larger differences in expansion, a lower temperature and longer time is preferred.

The combination of a curved optical substrate with a predefined radius of curvature, with a coating comprising crystalline semiconductor layers, provides a highly reflective focusing mirror, suitable for use in high performance optical devices, in particular stable optical resonators. The final optical substrate may be pre-curved by using a suitable polishing method that provides the surface with a predetermined radius of curvature. The coating of the original growth substrate with a crystalline semiconductor layer of a specified layer pair design produces a Bragg mirror at the desired operating wavelength. The combination of a curved substrate and a crystalline coating provides a non-monolithic mirror assembly. This allows for adapting the final optical properties, including the center wavelength and transmission, and ideally the limiting absorption and scatter losses, of the mirror assembly precisely to fit the needs of the intended application. The choice of ROC depends on the details of the final application and we describe two typical ranges here. For cavities used in high precision spectroscopy, mirrors with ROCs in the range of 0.1 m - 10 m are common, though it should be understood that other values are possible. For large scale systems such as gravitational wave detectors, arm-lengths and corresponding ROCs are in the range of 1 km to 10 km. Here again it should be understood that other values for ROCs are possible, with minimum values of 0.1 km or below for small-scale test systems.

The optical coating may be a single crystal optical coating, wherein the step of forming the optical coating on the growth substrate may comprise depositing the optical coating via an epitaxial growth technique, for example molecular beam epitaxy, MBE, or organometallic vapor-phase epitaxy. For the lowest optical losses, particularly absorption, MBE may be preferred due to the lower achievable background doping levels.

The step of forming the optical coating may further comprise lithographically defining the lateral geometry of the coating. Thereby, the lateral geometry of the coating may be controlled to the micrometer or sub-micrometer level, depending on the details of the process employed.

The step of forming the optical coating may further comprise extruding the defined lateral geometry of the coating into the optical coating and at least partially into the growth substrate by means of chemical etching.

The step of forming the optical coating may further comprise singulating the optical coating using mechanical dicing or grinding processes and removing the remaining growth substrate from the optical coating via selective chemical etching, before or after bonding as described above.

The method may further comprise removing any remaining growth substrate post-bonding by means of chemical etching.

For a single-crystal multilayer, the growth substrate may comprise GaAs, Ge, or Si; wherein the optical substrate may be transparent, in particular at a wavelength of 1064 nm or 1550 nm, and wherein the top surface of the optical substrate may be polished.

The optical substrate may comprise, but is not limited to, SiO₂, Si, sapphire, or ultra-low expansion glass, ULE.

Certain choices of materials for the optical substrate may offer a very similar coefficient of thermal expansion to the transferred coating, e.g. AIGaAs on c-axis oriented sapphire. Thus, temperature variations may be less likely to introduce strain in the mirror, in particular at the interface between the coating and optical substrate.

The optical coating may comprise crystalline semiconductor layers being monocrystalline epitaxial layers based on an AIGaAs ternary alloy, wherein the first and second type comprise AlₓGa₁₋ₓAs with 0 < x < 1; wherein for the layers of the first type x is smaller than for layers of the second type.

A high x yields a lower refractive index, while a low x yields a higher refractive index. Epitaxial AIGaAs with varying Al content thus may provide the possibility for a significant reduction in the mechanical losses, while at the same time providing a high reflectivity and low optical absorption for the mirror.

In the mirror assembly, the optical substrate may be transparent, in particular at a wavelength of 1064 nm or 1550 nm, and the surface of the optical substrate may be polished, ideally to a roughness less than 1 nm RMS. If access to transmitted light is desired the substrate should be highly transparent at the wavelength of interest and may additionally include an anti-reflection coating to eliminate spurious reflections from the uncoated backside of the optical substrate.

In particular a transparent optical substrate may have in turn a reduced absorption which may be beneficial for applications with long propagation lengths.

In the mirror assembly the coating / crystalline coating may be attached to the optical substrate by at least one of van der Waals forces bonding or covalent bonding.

Using van der Waals bonding, the stacked layers may be attached to the optical substrate in a process which is easy to realize, namely direct contact of two sub-nm roughness surfaces with no chemical treatments or post-bond annealing. The types of bonding, van der Waals bonding and/or covalent bonding may also be combined to a predetermined degree. Also, the bonding step may be combined with or followed by an annealing step. Annealing may be performed at temperatures from just over room temperature up to about 700° C. Temperatures above about 400°C may be applied only when the surface is properly protected, otherwise arsenic may leach out of the AIGaAs.

In the method described above, the growth substrate may comprise GaAs, Ge, or Si.

The growth substrate may in particular be selected based on the operating wavelength for the envisaged application. Thus, various crystalline semiconductor materials systems such as GaAs, Ge, or Si may be chosen for the growth substrate. Furthermore, InP, or GaN/AIN may also be used.

The above and other aspects, features and advantages of the present disclosure will become more apparent from the following detailed description when taken in conjunction with the accompanying drawings.

### Brief Description of the Drawings

- Fig. 1:: A schematic view of a curved coating stack on a carrier substrate.
- Fig. 2A - 2D:: A schematic view of the manufacturing process steps according to the present disclosure.
- Fig. 3A - 3D:: A schematic view of the process steps for a slightly modified process according to the present disclosure.
- Fig. 4: Detailing the sequence of steps according to the present disclosure.

### Detailed Description

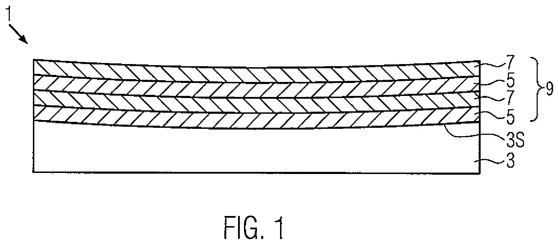

Fig. 1 illustrates a side view of a low absorption mirror assembly. Fig. 1 discloses a coating 9 on an optical substrate 3. Between the coating 9 and the optical substrate 3, the optical substrate 3 has a surface 3S. The coating may comprise a monocrystalline Bragg mirror bonded to the optical substrate 3. The optical substrate 3 may be curved. It should be understood, again, that the term monocrystalline refers to a low defect density single-crystal film as can be produced via epitaxial growth techniques, MBE, MOVPE, LPE, etc. Throughout this text, the terms crystalline and monocrystalline may be used interchangeably. The mirror assembly 1 of Fig. 1 is only schematically depicted. The curved optical substrate 3 is provided so as to impart the desire curvature into the coating, which may comprise stacked monocrystalline layers. The coating 9 is depicted with layers 5 and 7 in an oversimplified schematic drawing having only four layers. It should be understood, however, that the coating 9 typically comprises many more layers. The maximum reflectivity of the coating may be determined by the refractive index contrast of the individual layers, the total number of layers, as well as the refractive index of the substrate - asymptotically approaching a reflectivity of 100%. The number of layers for the present example may be about 40 pairs of layers, i.e. 80 total layers, but other numbers of layers such as 100-120 total layers may be used for such a structure. The layers 5 and 7 as shown in Fig. 1 are monocrystalline semiconductor layers alternating with respect to having a high and a low index of refraction, respectively. In Fig. 1, it may be assumed that layers 5 correspond to the layers having a low index of refraction whereas layers 7 correspond to the layers having a high index of refraction. Typically the difference in refractive index should be as large as possible; for example with AIGaAs at a wavelength of 1064 nm index values of 3.48 and 2.94 may be used for an implementation made from GaAs and Al_{0.92}Ga_{0.08}As layers respectively. The stack of layers 5 and 7 form a coating 9 that in combination with the growth substrate 21 form a structure denoted by reference sign 11.

The coating 9 of Fig. 1 is attached to the optical substrate 3 via direct bonding, i.e. with no intermediate adhesive layers. The alternating crystalline semiconductor high- and low- index layers 5 and 7 initially stick adhesively, i.e., via van der Waals forces to the surface of the optical substrate 3, because the surface of the optical substrate 3 is polished. Thus, the coating 9 may be deformed into a predetermined shape with respect to the curved optical substrate 3 and will maintain that configuration due to the adhesive force. Typical values of the surface RMS roughness are on the order of 1 nm or below. As indicated above, the layers are formed of alternating AlₓGa₁₋ₓAs / Al_{y}Ga_{1-y}As, 0 < x < 1, 0 < y < 1 with varying aluminum content. It should be noted that the larger the difference in Al content, the larger the difference in refractive index between the layers. In such a case, it typically takes less layer pairs to reach a high reflectivity. Also the amount of aluminum controls the wavelength at which the layers start absorbing light. A mirror with zero Al content in the high index layers will be transparent to a minimum wavelength of approximately 870 nm at room temperature. Such a mirror may operate with high reflectivity out to a maximum wavelength approaching 10 µm with suitable adjustment of the individual layer thicknesses. However, for operation at shorter wavelengths, e.g. for visible light down to 650 nm, the minimum x value corresponding to the Al content may be at least 50%.

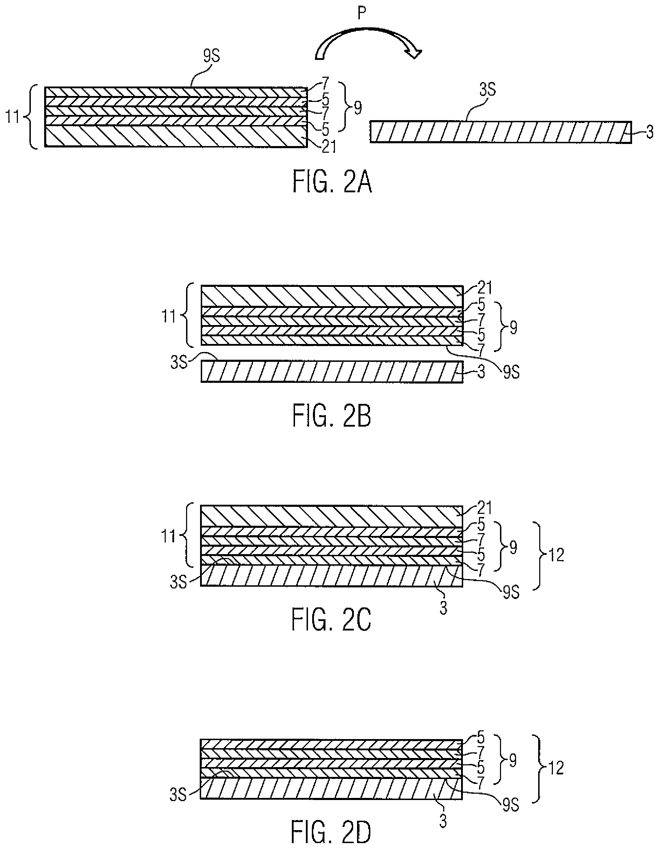

Figs. 2A - 2D illustrate schematically the process according to the present invention. Fig. 2A shows a growth or donor substrate 21. The growth substrate 21 may comprise monocrystalline GaAs, germanium, Ge, or silicon, Si, although other materials may also be possible, depending on the desired operating wavelength for the application. Such materials may additionally comprise InP, or GaN/AIN. The thickness of the growth substrate is typically around 300-500 µm though values between 50 µm and 1 mm are possible. Fig. 2A illustrates four layers 5, 7 formed on the growth substrate 21. These layers 5, 7 have alternating refractive indices, as discussed above with respect to Fig. 1. It should be understood that the number of layers, 5, 7 may be larger than four. The layers 5, 7 form an optical coating 9. The optical coating 9 together with the growth substrate 21 forms a structure 11, similar to the structure 11 of Fig. 1. The optical coating may have a top surface 9S facing away from the growth substrate 21. The top surface 9S may be polished preferably to a maximum roughness of ∼1 nm RMS in order to enable successful direct bonding.

Fig. 2A also shows a second or optical substrate 3. The optical substrate 3 will have two surfaces, one of which may be selected as the top surface or working surface 3S of the substrate 3. This surface 3S may be polished. Before combining the growth substrate 21 having the coating 9 including the layers, 5, 7, formed thereon, the structure 11 including the growth substrate 21 with the coating formed thereon is flipped or rotated as indicated by the arrow P. Thus, the entire structure 11 will become oriented upside down with respect to the previous step, such that now the growth substrate 21, part of the structure 11, is farthest from the optical substrate 3. Thereby, the top surface 9S of the coating 9 will face the top surface 3S of the optical surface 3. It should be understood that at least in principle it may also be possible to flip the optical surface 3 such that the arrow P may be reversed in direction. The result of the flipping step is indicated in Fig. 2B. By flipping the structure 11 and thereby the coating 9 upside down, as indicated in Figs. 2A and 2B, a majority of growth defects may become buried at the bonding interface instead of in the top layers of the reflective coating. This may lead to a reduction in the coating scatter loss to levels below 5 ppm, which is an improvement of a factor of 2 - 4 compared to previously applied processes. Mirrors manufactured with this process are thus capable of finesse levels in the few-hundred-thousand range, on par with the best coatings available today.

Fig. 2C shows the further step of bonding together the flipped structure 11 including the coating 9 and the growth substrate 21 onto the optical substrate 3. To achieve proper bonding a press may be used. Further, the entire structure shown in Fig. 2C can be annealed in order to generate a stronger bond between the coating and optical substrate. After pressing and annealing the coating 9 onto the optical substrate 3, the coating 9 is bonded to the optical substrate 3 forming a mirror assembly 12. As is illustrated in Fig. 2C, the growth substrate 21 is still attached to the mirror assembly 12.

Fig. 2D shows a process for removing the growth substrate 21 from the mirror assembly 12. This removal of the growth substrate 21 may be achieved by at least one of wet-etching, grinding, lapping, etc. such that the growth substrate 21 is detached from the coating. Previously described substrate removal processes such as epitaxial lift-off, ELO, or the Smart Cut process involving ion implantation and subsequent annealing may not be applicable for the production of such low loss coatings as depicted in Fig. 2D. ELO is not compatible with low index ternary AlₓGa₁₋ₓAs alloys, i.e. for x>50%, while the ion implantation step required in the Smart Cut process may prove damaging to highly sensitive multilayers. Thus, the donor substrate removal process may comprise the following steps: In a first step, the growth substrate 21 is mechanically thinned by, for example, a grinding process. Then, the growth substrate material is chemically removed from the mirror assembly 12, i.e. from coating 9, thereby obtaining a detached coating 9. The detached coating 9 having the growth substrate 21 removed is depicted in Fig. 2D.

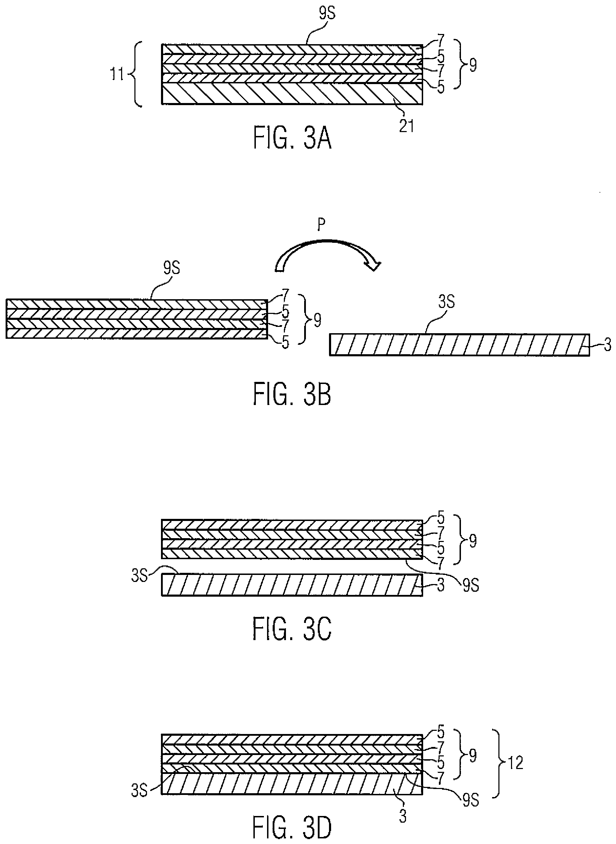

Fig. 3A - 3D illustrate an alternative sequence of the steps depicted in Figs. 2B - 2D. Thus, Figs. 3A - 3D illustrate a slightly modified process compared to the process disclosed in Figs. 2A - 2D. It should be understood that the same elements are denoted with the same reference numbers in both sequences of Figures. Fig. 3A illustrates a starting point of this slightly modified process. The structure 11 comprising the growth substrate 21 together with the coating stack 9 may be the same as shown in the left part of Fig. 2A. However, in contrast to the process disclosed in Figs. 2A - 2D, in Figs. 3A - 3D the growth substrate 21 atop of the coating 9 is now removed from the coating 9, prior to the bonding of the coating 9 onto the top surface 3S of the optical substrate 3. This is further illustrated in Fig. 3B. Fig. 3B also indicates an arrow P which should indicate the flipping or rotating of the coating 9. Again, at least in principle the optical substrate 3 may be flipped instead of flipping the coating 9. In contrast to Fig. 2A and 2B, the coating 9 is now rotated without the growth substrate 21. Then the free-standing coating 9, lacking the growth substrate 21, will be bonded onto the optical substrate, as is further illustrated in Figs. 3C and 3D. Again, as already described with respect to Figs. 2A - 2D, the bonding process may be assisted by a pressing step and is typically followed by an annealing step to strengthen the bond.

For all of Figs. 3A - 3D, it should be understood, that the optical substrate and the coating may be transparent at the desired operating wavelength and should be polished to a sufficient quality for successful bonding, typically <1 nm RMS roughness.

Whereas Figs. 3A - 3D have been shown with a planar optical substrate 3, it should be understood that the optical substrate may be curved and may have a pre-determined radius of curvature between 0.1 and 10 m, with a typical value of 1 m or below, or a radius of curvature between 0.5 km and 10 km.

If the final application requires an extremely stable mirror structure with low optical losses and low Brownian noise, the coating should consist of a monocrystalline semiconductor multilayer. One potential example is AIGaAs-based coatings, which typically exhibit a limiting loss angle, i.e., the inverse of the mechanical quality factor, of a maximum of 1 x 10⁻⁴ to a value below 10⁻⁶ depending on the system operating temperature. In addition, such coatings can typically provide a reflectivity >99.99%, with a total absorption <1 ppm for center wavelengths covering the near infrared spectral region, i.e., 1000-1600 nm. Typical values for center wavelengths are 1064 nm and 1550 nm, though the range of -600 nm to -10 µm is possible with GaAs/AIGaAs multilayers.

The monocrystalline mirror layers typically have a total thickness in the range of 5-20 µm, while the lateral dimensions or diameters vary from about 5 mm up to about 200 mm, and may even exceed 200 mm in extreme applications. As is indicated in the Figs., these structures are continuous in the curved plane.

Transparency of the curved optical substrate is also beneficial for reducing the thermal load in the interferometer/cavity system and to reduce thermo-optic instabilities.

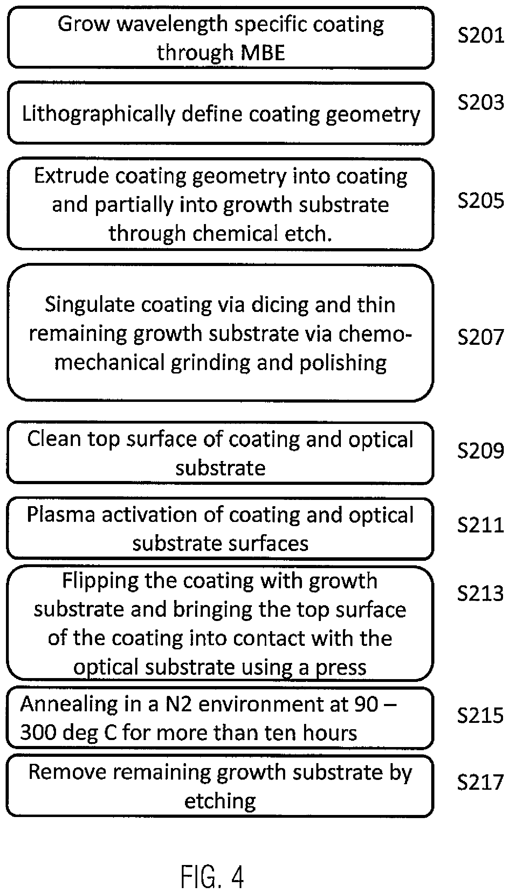

Fig. 4 discloses a typical sequence of steps for this process.

In step S200, a growth substrate and an optical substrate are provided. Both the growth substrate and the optical substrate, exhibit two surfaces, one of which may be identified as the top surface of the respective substrate, the other as the bottom surface. For both the growth substrate and the optical substrate, one of the two surfaces of each substrate will be chosen as the surface on which further work is applied. Without losing any generality, that surface will then be identified as being the top surface of the respective substrate.

In step S201, a wavelength specific coating is grown by molecular beam epitaxy, MBE on the growth substrate. When forming the optical coating on the growth substrate, the optical coating has a top surface facing away from the growth substrate.

In step S203, the coating geometry is lithographically defined in order to precisely control the coating geometry to the micrometer level.

In the next step, S205, the coating geometry is extruded into the coating and also partially into the growth substrate. This is achieved through chemical etching.

In the next step, S207, the coating is singulated via mechanical dicing or etching followed by chemo-mechanical grinding. This may also include lapping and polishing to reduce the thickness of the original growth substrate. The thickness of the growth substrate after this step may be between 100 µm - 200 µm. In one embodiment the growth substrate may be completely removed with a subsequent chemical etching step before bonding.

In the next step, S209, the top surface of the coating is cleaned to remove any particles, debris, or unwanted contaminating films. Similarly, the top surface of the optical substrate is cleaned. The cleaning may be achieved using specific solvents and detergent solutions.

The next step, S211, includes chemical treatment of the coating and optical substrate to prepare for bonding. A preferred implementation may be plasma activation of the coating and the optical substrate surfaces.

The next step, S213, includes flipping the coating with growth substrate, i.e. the coating on the growth substrate together or the coating on its own if the growth substrate has previously been removed, and bringing the top surface of the coating into contact with the top surface of the optical substrate and pressing both surfaces into intimate contact.

The shape of the press used to realize direct contact between the coating and optical substrate may be chosen so as to follow the shape of the optical substrate. Thus if the optical substrate has a concave surface it may be beneficial to use a convex press of equal and opposite or smaller radius of curvature in order to press the coating into contact with the optical substrate surface. On the other hand, if the optical substrate is planar, it may be beneficial to use a planar press.

Typically, in order to achieve direct contact between the top surface of the coating and the optical substrate, the pressure exerted by the press may be held for a specific time and while said pressure is exerted, the entire object may be stored in a controlled environment. Thus, a further optional step may be to store the entire - i.e. clamped - assembly under inert conditions, one example being in a dry N₂-environment.

As a next step, S215, the bonded optical substrate and coating are annealed at temperatures in the range of 90 - 300 °C, in particular between 90 °C - 125 °C. The annealing step may be performed for one to twenty four hours.

After finishing the annealing step, a further cleaning step, S217, is conducted. Next a specific solution such as a H₂O₂:NHₐOH is applied to remove any remaining growth substrate, in this example assuming GaAs. Optical substrates that are very sensitive to chemical etching processes should be carefully protected during the substrate removal step to avoid damaging the substrate. If the substrates are too delicate, chemical etching may be avoided post-bonding and the growth substrate would be removed prior to the bonding step.

It should be understood that while Figs. 2A - 2D disclose removal of the growth substrate after the bonding step in S217, the removal of the growth substrate may also be performed prior to the bonding step S213, as is disclosed in Figs. 3A - 3D.

In summary, by flipping or rotating the coating upside down, a majority of growth defects become buried at the bond interface instead of being present in the top layers of the reflective coating. This leads to a reduction in the coating scatter loss to levels below 5 ppm, thereby an improvement of a factor of 2 - 4 compared to previously known processes. Mirrors manufactured with this process are thus capable of finesse levels in the few-hundred-thousand range, on par with the best coatings available today.

While the invention has been shown and described with reference to a certain preferred embodiment thereof, it will be understood by those skilled in the art that various changes in form and details may be made therein without departing from the scope of the invention as defined by the appended claims.

## Claims

1. A method for manufacturing a direct-bonded optical coating (9), comprising:
providing a growth substrate (21);
providing an optical substrate (3);
wherein the optical substrate (3) is curved having a radius of curvature, ROC, between 0.1 m and 10 m or between 1 km and 10 km;
forming the optical coating (9) directly on the growth substrate (21), the optical coating (9) having a top surface (9S) facing away from the growth substrate (21);
flipping the optical coating (9) such that the top surface (9S) of the optical coating (9) faces the optical substrate (3);
directly bonding the top surface (9S) of the optical coating (9) to the optical substrate (3) without any intermediate adhesive layers; and
detaching the growth substrate (21) from the optical coating (9) after the bonding step;
wherein the bonding step further comprises:
pressing the optical coating (9) into direct contact with the optical substrate (3) surface using a press, thereby obtaining a bond between the optical coating (9) and the optical substrate (3), wherein if the optical substrate (3) has a concave surface using a convex press of equal and opposite or smaller radius of curvature,
wherein the pressing is realized by clamping together the optical substrate (3), optical coating (9), and the press at a controlled pressure value;
and further comprising annealing of the bonded optical substrate (3) for example at a temperature between 90 °C - 300 °C and for times spanning one to twenty four hours.

2. The method according to claim 1, the optical coating (9) being a single crystal optical coating (9), wherein the step of forming the optical coating (9) on the growth substrate (21) comprises depositing the optical coating (9) via an epitaxial growth technique, for example molecular beam epitaxy, MBE, or organometallic vapor-phase epitaxy.

3. The method according to claim 1 or 2, wherein the step of forming the optical coating (9) further comprises lithographically defining the lateral geometry of the coating (9)

4. The method according to claim 3, wherein the step of forming the optical coating (9) further comprises extruding the defined lateral geometry of the coating (9) into the optical coating (9) and at least partially into the growth substrate (21) by means of chemical etching.

5. The method according to claim 4, wherein the step of forming the optical coating (9) comprises singulating the optical coating (9) using mechanical dicing and/or grinding processes in order to thin and separate the remaining substrate via selective chemical etching.

6. The method according to claim 1, further comprising removing any remaining growth substrate (21) post-bonding by means of chemical etching.

7. The method according to claim 1, wherein the growth substrate (21) comprises GaAs, Ge, or Si; wherein the optical substrate (3) is transparent, in particular at a wavelength of 1064 nm or 1550 nm, and wherein the top surface (3S) of the optical substrate (3) is polished.

8. The method according to claim 1, wherein the optical substrate (3) comprises SiO₂, Si, sapphire, or ultra-low expansion glass, ULE.

9. The method according to claim 1, wherein the optical coating (9) comprises crystalline semiconductor layers (5, 7) being monocrystalline epitaxial layers based on an AIGaAs ternary alloy, wherein the first and second type comprise AlₓGa₁₋ₓAs with 0 < x < 1; wherein for the layers of the first type x is smaller than for layers of the second type.

## Patentansprüche

1. Verfahren zur Herstellung einer direkt gebondeten optischen Beschichtung (9), umfassend:
Bereitstellen eines Züchtungs-Substrats (21);
Bereitstellen eines optischen Substrats (3);
wobei das optische Substrat (3) mit einem Krümmungsradius (ROC) zwischen 0,1 m und 10 m oder zwischen 1 km und 10 km gekrümmt ist;
Ausbilden der optischen Beschichtung (9) direkt auf dem Züchtungs-Substrat (21), wobei die optische Beschichtung (9) eine von dem Züchtungs-Substrat (21) abgewandte Oberseite (9S) hat;
Wenden der optischen Beschichtung (9), so dass die Oberseite (9S) der optischen Beschichtung (9) dem optischen Substrat (3) zugewandt ist;
direktes Bonden der Oberseite (9S) der optischen Beschichtung (9) an das optische Substrat (3) ohne Zwischen-Haftschichten; und
Lösen des Züchtungs-Substrats (21) von der optischen Beschichtung (9) nach dem Bond-Schritt;
wobei der Bond-Schritt des Weiteren umfasst:
Pressen der optischen Beschichtung (9) in direkten Kontakt mit der Oberfläche des optischen Substrats (3) unter Verwendung einer Presse, um so eine Bindung zwischen der optischen Beschichtung (9) und dem optischen Substrat (3) zu erreichen, wobei, wenn das optische Substrat (3) eine konkave Oberfläche aufweist, eine konvexe Presse mit gleichem und entgegengesetztem oder kleinerem Krümmungsradius verwendet wird,
wobei das Pressen durch Zusammenklemmen des optischen Substrats (3), der optischen Beschichtung (9) und der Presse mit einem kontrollierten Druckwert realisiert wird;
und des Weiteren umfassend Tempern (annealing) des gebondeten optischen Substrats (3), beispielsweise bei einer Temperatur von 90 °C - 300 °C und über Zeiträume, die von 1 bis 24 Stunden dauern.

2. Verfahren nach Anspruch 1, wobei die optische Beschichtung (9) eine einkristalline optische Beschichtung (9) ist und der Schritt zum Ausbilden der optischen Beschichtung (9) auf dem Züchtungs-Substrat (21) Abscheiden der optischen Beschichtung (9) mittels eines Aufwachsverfahrens, beispielsweise Molekularstrahl-Epitaxie (MBE) oder metallorganischer Gasphasenepitaxie, umfasst.

3. Verfahren nach Anspruch 1 oder 2, wobei der Schritt zum Ausbilden der optischen Beschichtung (9) des Weiteren lithographisches Definieren der Lateralgeometrie der Beschichtung (9) umfasst.

4. Verfahren nach Anspruch 3, wobei der Schritt zum Ausbilden der optischen Beschichtung (9) des Weiteren Extrudieren der definierten Lateralgeometrie der Beschichtung (9) in die optische Beschichtung (9) und wenigstens teilweise in das Züchtungs-Substrat (21) hinein mittels chemischen Ätzens umfasst.

5. Verfahren nach Anspruch 4, wobei der Schritt zum Ausbilden der optischen Beschichtung (9) umfasst, dass die optische Beschichtung (9) unter Verwendung mechanischer Trenn- und/oder Schleifprozesse vereinzelt wird, um das verbleibende Substrat über selektives chemisches Ätzen zu verdünnen und zu trennen.

6. Verfahren nach Anspruch 1, das des Weiteren Entfernen von etwaigem verbliebenem Züchtungs-Substrat (21) nach Bonden mittels chemischen Ätzens umfasst.

7. Verfahren nach Anspruch 1, wobei das Züchtungs-Substrat (21) GaAs, Ge oder Si umfasst, das optische Substrat (3), insbesondere bei einer Wellenlänge von 1064 nm oder 1550 nm, transparent ist und die Oberseite (3S) des optischen Substrats (3) poliert wird.

8. Verfahren nach Anspruch 1, wobei das optische Substrat (3) SiO₂, Si, Saphir oder Ultra-Low-Expansion-Glas (ULE) umfasst.

9. Verfahren nach Anspruch 1, wobei die optische Beschichtung (9) kristalline Halbleiterschichten (5, 7) umfasst, die monokristalline epitaktische Schichten auf Basis einer ternären AlGaAs-Legierung sind, wobei der erste und zweite Typ AlₓGa₁₋ₓAs umfasst, dabei 0 < x < 1 gilt, und für die Schichten des ersten Typs x kleiner ist als für Schichten des zweiten Typs.

## Revendications

1. Procédé de fabrication d'un revêtement optique (9) à liaison directe, comprenant :
la fourniture d'un substrat de croissance (21) ;
la fourniture d'un substrat optique (3) ;
le substrat optique (3) étant incurvé suivant un rayon de courbure, ROC, entre 0,1 m et 10 m ou entre 1 km et 10 km ;
la formation du revêtement optique (9) directement sur le substrat de croissance (21), le revêtement optique (9) ayant une surface de dessus (9S) orientée à l'opposée du substrat de croissance (21);
le retournement du revêtement optique (9) de telle sorte que la surface de dessus (9S) du revêtement optique (9) soit face au substrat optique (3) ;
la liaison directe de la surface de dessus (9S) du revêtement optique (9) au substrat optique (3), sans aucune couche adhésive intermédiaire ; et
le détachement du substrat de croissance (21) du revêtement optique (9) après l'étape de liaison ;
l'étape de liaison comprenant en outre :
le pressage du revêtement optique (9) en contact direct avec la surface du substrat optique (3) en utilisant une presse, ce qui permet d'obtenir une liaison entre le revêtement optique (9) et le substrat optique (3), où si le substrat optique (3) a une surface concave, en utilisant une presse convexe ayant un rayon de courbure égal et opposé ou inférieur,
le pressage étant réalisé en serrant ensemble le substrat optique (3), le revêtement optique (9) et la presse sous une valeur de pression contrôlée;
et comprenant en outre un recuit du substrat optique (3) lié, par exemple à une température entre 90 °C et 300 °C et pendant des durées s'étendant de une à vingt-quatre heures.

2. Procédé selon la revendication 1, le revêtement optique (9) étant un revêtement optique (9) monocristallin, dans lequel l'étape de formation du revêtement optique (9) sur le substrat de croissance (21) comprend le dépôt du revêtement optique (9) par le biais d'une technique de croissance épitaxiale, par exemple une épitaxie par jets moléculaires, MBE, ou une épitaxie en phase vapeur aux organométalliques.

3. Procédé selon la revendication 1 ou 2, dans lequel l'étape de formation du revêtement optique (9) comprend en outre la définition par lithographie de la géométrie latérale du revêtement (9).

4. Procédé selon la revendication 3, dans lequel l'étape de formation du revêtement optique (9) comprend en outre l'extrusion de la géométrie latérale définie du revêtement (9) dans le revêtement optique (9) et au moins partiellement dans le substrat de croissance (21) par gravure chimique.

5. Procédé selon la revendication 4, dans lequel l'étape de formation du revêtement optique (9) comprend la singularisation du revêtement optique (9) en utilisant des opérations de découpage et/ou de meulage mécaniques afin d'amincir et séparer le substrat restant par gravure chimique sélective.

6. Procédé selon la revendication 1, comprenant en outre l'élimination de tout substrat de croissance (21) résiduel éventuel après liaison par gravure chimique.

7. Procédé selon la revendication 1, dans lequel le substrat de croissance (21) comprend du GaS, du Ge ou du Si ; dans lequel le substrat optique (3) est transparent, en particulier à une longueur d'onde de 1064 nm ou 1550 nm, et dans lequel une surface de dessus (3S) du substrat optique (3) est polie.

8. Procédé selon la revendication 1, dans lequel le substrat optique (3) comprend du SiO₂, du Si, du saphir ou du verre à très faible dilatation, ULE.

9. Procédé selon la revendication 1, dans lequel le revêtement optique (9) comprend des couches semi-conductrices cristallines (5, 7) qui sont des couches épitaxiales monocristallines basées sur un alliage ternaire AIGaAs, le premier et le second type comprenant AlₓGa₁₋ₓAs avec 0 < x < 1 ; où pour les couches du premier type, x est plus petit que pour les couches du second type.
